# EUROPEAN PATENT SPECIFICATION

(11) **EP 3 185 317 B1**
(45) Date of publication and mention of the grant of the patent: **02.12.2020**
(21) Application number: 16165131.0
(22) Date of filing: 13.04.2016
(51) Int. Cl.: H01L 33/50, F21V 7/05, F21K 9/64

(54) **PHOSPHOR DEVICE AND MANUFACTURING METHOD THEREOF**
PHOSPHORVORRICHTUNG UND HERSTELLUNGSVERFAHREN DAFÜR
DISPOSITIF AU PHOSPHORE ET SON PROCÉDÉ DE FABRICATION

(30) Priority: 22.12.2015 TW 104143205
(43) Date of publication of application: 28.06.2017
(60) Divisional application: 18210432.3
(73) Proprietor: Delta Electronics, Inc., Taoyuan City 33370 (TW)
(72) Inventor: CHANG, Keh-Su, 33370 Guishan Industrial Zone, Taoyuan City (TW); CHOU, Yen-I, 33370 Guishan Industrial Zone, Taoyuan City (TW); CHEN, Chi, 33370 Guishan Industrial Zone, Taoyuan City (TW)
(74) Representative: 2K Patentanwälte Blasberg Kewitz & Reichel

(56) References cited:
- EP-A2- 2 339 655
- WO-A2-2012/135744
- US-A1- 2005 184 298
- US-A1- 2011 227 477
- US-A1- 2012 039 065
- US-A1- 2012 267 998
- US-A1- 2013 234 591
- US-A1- 2015 184 066

## Description

### FIELD OF THE INVENTION

The present invention relates to a phosphor device, and more particularly to a phosphor device and a manufacturing method thereof.

### BACKGROUND OF THE INVENTION

In recent years, a variety of projectors have been widely used in various video applications. For example, projectors can be used for making presentations, holding meetings or giving lectures in classrooms, boardrooms, conference rooms or home theaters. By the projector, an image signal from an image signal source can be enlarged and shown on a display screen. For reducing power consumption and overall volume, the illumination system of the current projector employs a solid-state light-emitting element (e.g. light emitting diode or laser diode) to replace the conventional high intensity discharge (HID) lamp.

Generally, the illumination system of the projector may emit three primary color lights, i.e. a red light (R), a green light (G) and a blue light (B). Among three primary color solid-state light-emitting elements including a red solid-state light-emitting element, a green solid-state light-emitting element and a blue solid-state light-emitting element, the blue solid-state light-emitting element has the highest luminous efficiency. Since the red solid-state light-emitting element and the green solid-state light-emitting element have poor luminous efficiency, the red light or the green light may be produced by using a blue solid-state light-emitting element and a wavelength conversion device (e.g. a phosphor wheel). That is, the uses of the blue solid-state light-emitting element and the phosphor wheel may directly emit the red light or the green light in replace of the red solid-state light-emitting element or the green solid-state light-emitting element. Consequently, the luminous efficiency of the whole illumination system is enhanced and the manufacturing cost of the illumination system is reduced.

However, it still has some drawbacks of using a solid-state light-emitting element to emit an excitation light and a phosphor wheel to convert the wavelength of the excitation light. When using a solid-state light-emitting element and a phosphor wheel coated with a phosphor agent to emit an excitation light to be separated as color lights for projecting, the luminous intensity or the saturation level of a color light may be not enough.

Document US 2013/0234591 A1 discloses a LED device comprising a yellow emitting phosphor layer on which a second red emitting phosphor layer is formed.

Therefore, there is a need of providing an improved illumination system and an improved projection apparatus in order to eliminate the above drawbacks.

### SUMMARY OF THE INVENTION

It is an object of the present invention to provide a phosphor device and a manufacturing method thereof for overcoming at least one of the above-mentioned drawbacks encountered by the prior arts.

The present invention provides a phosphor device according to claim 1 and claim 2 and a manufacturing method thereof according claim 14. By utilizing a phosphor layer including a first phosphor agent and a second phosphor agent, the luminous intensity of a color light, which is included in a second waveband light converted by the first phosphor agent, can be increased through the conversion of the second phosphor agent.

The present invention also provides a phosphor device and a manufacturing method thereof. Since a second phosphor layer including a first phosphor agent and a second phosphor agent is formed behind a first phosphor layer includes only the first phosphor agent along an optical path, most of the energy of a first waveband light is decreased by the first phosphor agent of the first phosphor layer, such that the conversion efficiency of the second phosphor agent is enhanced.

In accordance with an aspect of the present invention, there is provided a phosphor device of an illumination system emitting a first waveband light to the phosphor device so as to be converted into a second waveband light. The phosphor device includes a substrate and a first phosphor layer formed on the substrate. The first phosphor layer includes a first ingredient and a second ingredient. The first waveband light is converted into a first color light and a second color light by the first ingredient. The second ingredient is distributed over the first ingredient for converting the first waveband light into a third color light. The range of the spectrum of the second color light and the range of the spectrum of the third color light are at least partially overlapped, and the first color light, the second color light and the third color light are integrated as the second waveband light.

In accordance with a further aspect of the present invention, there is provided a manufacturing method of a phosphor device. The manufacturing method includes steps of providing a substrate, and forming a first phosphor layer on the substrate. The first phosphor layer includes a first phosphor agent for converting a first waveband light into a second waveband light comprising a first color light and a second color light, and includes a second phosphor agent for converting the first waveband light into the second color light, thereby increasing the luminous intensity of the second color light outputted by the phosphor device.

The above contents of the present invention will become more readily apparent to those ordinarily skilled in the art after reviewing the following detailed description and accompanying drawings, in which:

### BRIEF DESCRIPTION OF THE DRAWINGS

FIG. 1A schematically illustrates a phosphor device including a reflective substrate and an illumination system including the phosphor device according to an embodiment not forming part of the present invention;
FIG. 1B schematically illustrates the structure of the phosphor device as shown in FIG. 1A;
FIG. 2A schematically illustrates a phosphor device including a transmissive substrate and an illumination system including the phosphor device according to an embodiment not forming part of the present invention;
FIG. 2B schematically illustrates the structure of the phosphor device as shown in FIG. 2A;
FIG. 3 schematically illustrates the structure of a phosphor device including a reflective substrate according to an embodiment forming part of the present invention;
FIG. 4 schematically illustrates the structure of a phosphor device including a transmissive substrate according to an embodiment forming part of the present invention;
FIG. 5 schematically illustrates an intensity-wavelength diagram of visible lights of a phosphor device including a yellow phosphor agent and a red phosphor agent of the present invention, and a phosphor device utilizing a yellow phosphor agent and a phosphor device utilizing a red phosphor agent of prior art;
FIG. 6A schematically illustrates a phosphor device including a reflective substrate and an illumination system including the phosphor device according to an embodiment forming part of the present invention;
FIG. 6B schematically illustrates the structure of the phosphor device as shown in FIG. 6A;
FIG. 7A schematically illustrates a phosphor device including a transmissive substrate and an illumination system including the phosphor device according to an embodiment forming part of the present invention; and
FIG. 7B schematically illustrates the structure of the phosphor device as shown in FIG. 7A.

### DETAILED DESCRIPTION OF THE PREFERRED EMBODIMENT

The present invention will now be described more specifically with reference to the following embodiments. It is to be noted that the following descriptions of preferred embodiments of this invention are presented herein for purpose of illustration and description only. It is not intended to be exhaustive or to be limited to the precise form disclosed.

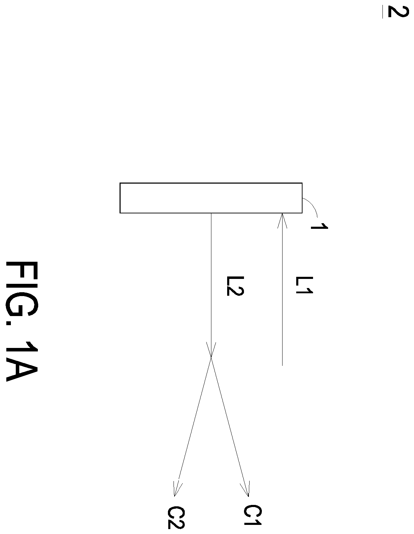

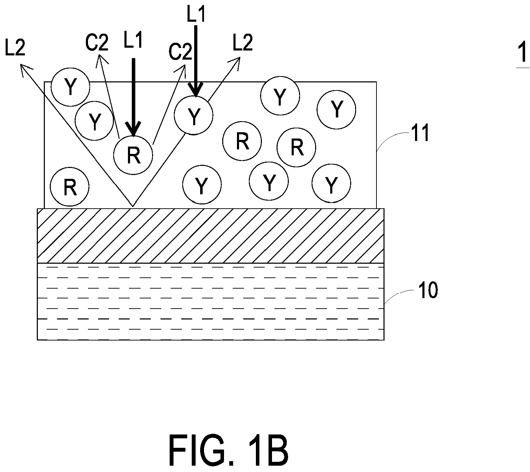

FIG. 1A schematically illustrates a phosphor device including a reflective substrate and an illumination system including the phosphor device according to an embodiment not forming part of the present invention. FIG. 1B schematically illustrates the structure of the phosphor device as shown in FIG. 1A. As shown in FIG. 1A and FIG. 1B, a phosphor device 1 of an illumination system 2, in which the illumination system 2 emits a first waveband light L1, includes a substrate 10 and a first phosphor layer 11. The first phosphor layer 11 includes a first phosphor agent Y and a second phosphor agent R. The first phosphor agent Y is formed on the substrate 10 for converting the first waveband light L1 into a second waveband light L2. The second waveband light L2, which could be separated by optical device for projecting, includes a first color light C1 and a second color light C2. The second phosphor agent R is distributed over the first phosphor agent Y for converting the first waveband light L1 into the second color light C2 so as to increase the luminous intensity of the second color light C2.

It should be noted that in a manufacturing method of the phosphor device 1, after the substrate 10 is provided, the first phosphor layer 11 including the first phosphor agent Y and the second phosphor agent R is formed on the substrate 10. The second phosphor agent R is utilized for converting the first waveband light L1 into enhancing the second color light C2, thereby increasing the luminous intensity of the second color light C2 outputted by the phosphor device 1. The second phosphor agent R can be added in the first phosphor layer 11 with an average distribution or a gradient distribution, such that the second phosphor agent R is distributed over the first phosphor agent Y. Certainly, the second phosphor agent R can be mixed with the first phosphor agent Y as a mixture in a mixing manner. Alternatively, the second phosphor agent R and the first phosphor agent Y can be formed as a plurality of segments. The segments are for example arranged on the first phosphor layer 11 with a pie-shaped distribution, but not limited thereto. The segment each includes the first phosphor agent Y or the second phosphor R, or every one of the segment includes the first phosphor agent Y and the second phosphor agent R simultaneously.

In this embodiment and the following embodiments, the first phosphor agent Y is for example a yellow phosphor agent, but not limited thereto. Meanwhile, the second phosphor agent R is for example a red phosphor agent, but not limited thereto. In some situations, the second phosphor agent R may be a green phosphor agent. The second phosphor agent R is to enhance the intensity and adjust the color saturation level of at least one of the color lights included in the excitation light (the second waveband light L2), which is excited by the first phosphor agent Y. Furthermore, the symbols (letters) "Y" and "R" are illustrated for indicating the first phosphor agent and the second phosphor agent but not for limiting the colors of the first phosphor agent and the second phosphor agent.

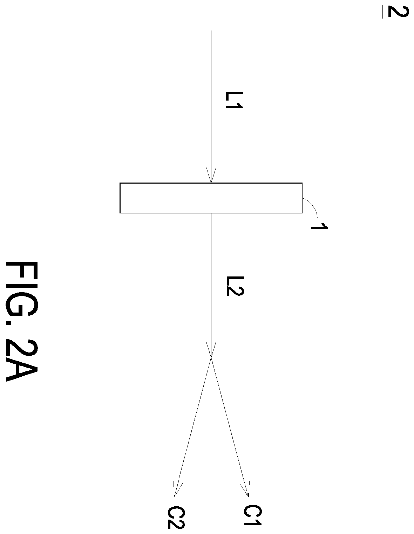

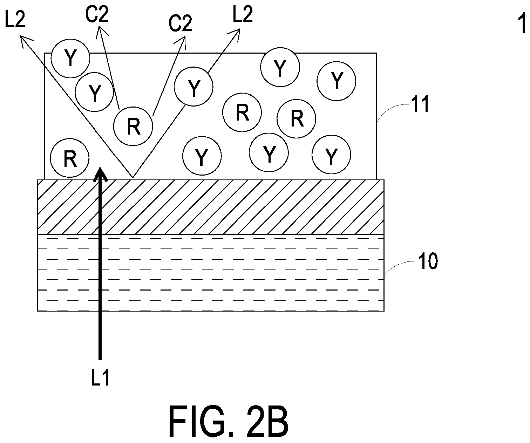

FIG. 2A schematically illustrates a phosphor device including a transmissive substrate and an illumination system including the phosphor device according to an embodiment not forming part of the present invention. FIG. 2B schematically illustrates the structure of the phosphor device as shown in FIG. 2A. As shown in FIG. 2A and FIG. 2B, a phosphor device 1 of an illumination system 2 includes a substrate 10 and a first phosphor layer 11. The first phosphor layer 11 is similar with the first phosphor layer 11 described in the previous embodiment, and is not redundantly described herein. In this embodiment, the substrate 10 is a transmissive substrate.

It should be noted that the phosphor device 1 of the present invention can be considered or realized in another way. In an embodiment, the first phosphor layer 11 is formed on the substrate and comprising a first ingredient and a second ingredient. The first ingredient can be the first phosphor agent, and so does the second ingredient. Furthermore, the first waveband light L1 is converted into a first color light C1 and a second color light C2 by the first ingredient. The second ingredient is distributed over the first ingredient for converting the first waveband light L1 into a third color light, in which the range of the spectrum of the second color light C2 and the range of the spectrum of the third color light are at least partially overlapped, and the first color light C1, the second color light C2 and the third color light are integrated as the second waveband light L2. Since the range of the spectrum of the second color light C2 and the range of the spectrum of the third color light are at least partially overlapped, at least a portion of the intensity of the second color light C2 is increased.

On the other hand, when the third color light converted by the second ingredient is similar with the second color light C2 converted by the first ingredient, the range of the spectrum of the second color light C2 and the range of the spectrum of the third color light are completely overlapped, and the phosphor device 1 meets the embodiments mentioned above. That is, the range of the spectrum of the color light converted by the second ingredient can be selected or adjusted to meet the practical demands but not limited by the embodiments of the present invention.

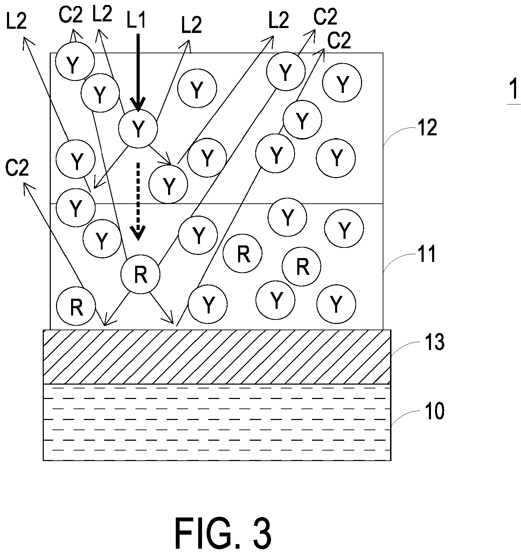

FIG. 3 schematically illustrates the structure of a phosphor device including a reflective substrate according to an embodiment of the present invention. As shown in FIG. 1B and FIG. 3, the phosphor device 1 further includes a second phosphor layer 12. In some embodiments, the substrate 10 is a reflective substrate, and the second phosphor layer 12 is disposed on the first phosphor layer 11. The second phosphor layer 12 includes the first phosphor agent Y for converting the first waveband light L1 into the second waveband light L2 and decreasing the energy of the first waveband light L1. That is, when the incident light (i.e. the first waveband light LI) is transmitted through the second phosphor layer 12, a large portion of energy of the incident light is converted. For example, the residue power of the first waveband light L1 inputted into the phosphor layer 11 is less than 40 watts, but not limited thereto.

The thickness of each of the first phosphor layer 11 and the second phosphor layer 12 is greater than or equal to 10 micrometers (i.e. ≥10 µm), and less than or equal to 500 micrometers (i.e. ≤500 µm). In preferred embodiments, the thickness of each of the first phosphor layer 11 and the second phosphor layer 12 is greater than or equal to 50 micrometers (i.e. ≥50 µm), and less than or equal to 200 micrometers (i.e. ≤200 µm). It should be noted that the thickness of the first phosphor layer 11 can be equal to or unequal to the thickness of the second phosphor layer 12. In addition, the weight percentage of the second phosphor agent R is less than 85% relative to the first phosphor agent Y.

In this embodiment, the phosphor device 1 of the present invention further includes a reflective coating 13. The reflective coating 13 is disposed between the substrate 10 and the first phosphor layer 11 for reflecting at least the second waveband light L2. An example of the reflective coating 13 includes but not limited to an all reflective coating, or a dichroic coating. While utilizing a dichroic coating as the reflective coating 13, a color light having the similar range of wavelength with the second waveband light L2 can be reflected by the reflective coating 13. Certainly, the first color light C1 and the second color light C2 both can be reflected by the reflective coating 13. While utilizing a reflective coating, almost all of visible light is reflected by the reflective coating 13.

In a manufacturing method of the phosphor device 1 including a reflective substrate, after the reflective substrate is provided, the first phosphor layer 11 including the first phosphor agent Y and the second phosphor agent R is formed on the reflective substrate. The second phosphor agent R is utilized for converting the first waveband light L1 into the third color light as described above, thereby increasing the luminous intensity of the second color light C2 outputted by the phosphor device 1. Next, the second phosphor layer 12 is formed on the first phosphor layer 11. The second phosphor layer 12 includes the first phosphor agent Y for converting the first waveband light L1 into the second waveband light L2 and decreasing the energy of the first waveband light L1. Moreover, the reflective coating 13 can be pre-coated on the substrate 10, or be formed on the substrate while processing the manufacturing method.

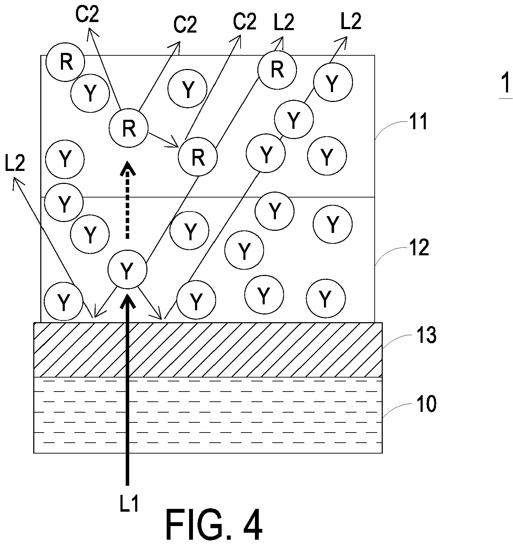

Please refer to FIG. 2B and FIG. 4. FIG. 4 schematically illustrates the structure of a phosphor device including a transmissive substrate according to an embodiment of the present invention. In this embodiment, the phosphor device 1 further includes a second phosphor layer 12. The substrate 10 is a transmissive substrate, and the second phosphor layer 12 is disposed between the first phosphor layer 11 and the substrate 10. The second phosphor layer 12 includes the first phosphor agent Y for converting the first waveband light L1 into the second waveband light L2 and decreasing the energy of the first waveband light L1 simultaneously. That is, when the incident light (i.e. the first waveband light L1) is transmitted through the second phosphor layer 12, a large portion of energy of the incident light is converted. For example, the residue power of the first waveband light L1 inputted into the phosphor layer 11 is less than 40 watts, but not limited thereto.

The thickness of each of the first phosphor layer 11 and the second phosphor layer 12 is greater than or equal to 10 micrometers, and less than or equal to 500 micrometers. In preferred embodiments, the thickness of each of the first phosphor layer 11 and the second phosphor layer 12 is greater than or equal to 50 micrometers, and less than or equal to 200 micrometers. The weight percentage of the second phosphor agent R is less than 85% relative to the first phosphor agent Y.

In an embodiment, the phosphor device 1 of the present invention further includes a reflective coating 13. The reflective coating 13 is disposed between the substrate 10 and the second phosphor layer 12 for reflecting the second waveband light L2. An example of the reflective coating 13 includes but not limited to a dichroic coating. While utilizing a dichroic coating as the reflective coating 13, a color light having the similar range of wavelength with the first waveband light L1 can be passed through the reflective coating 13, and a color light having the similar range of wavelength with the second waveband light L2 can be reflected by the reflective coating 13.

In a manufacturing method of the phosphor device 1 including a transmissive substrate, after the transmissive substrate is provided, the second phosphor layer 12 including the first phosphor agent Y is formed on the transmissive substrate. The first phosphor layer 11 is then formed on the second phosphor layer 12. The first phosphor layer 11 includes the first phosphor agent Y for converting the first waveband light L1 into the second waveband light L2, and the second waveband light L2 comprises a first color light C1 and a second color light C2. Next, the second phosphor agent R is added in the first phosphor layer 11 for converting the first waveband light L1 into the second color light C2, thereby increasing the luminous intensity of the second color light C2 outputted by the phosphor device 1. Moreover, the reflective coating 13 can be pre-coated on the substrate 10, or be formed on the substrate while processing the manufacturing method.

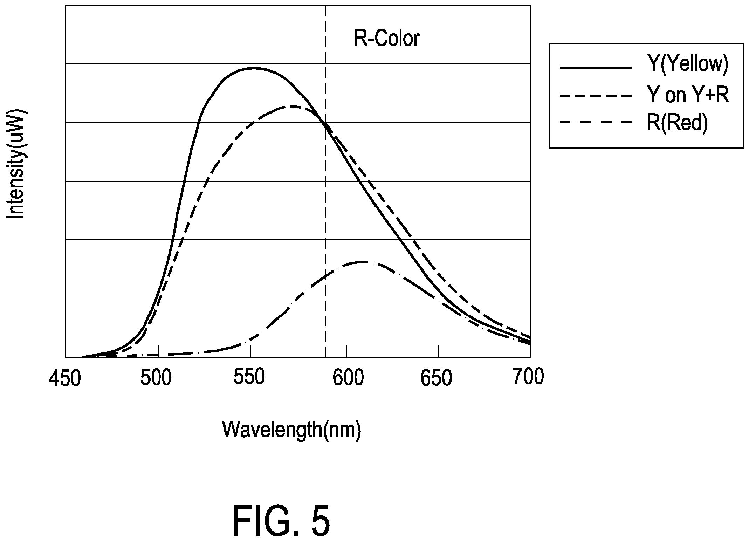

Please refer to FIG. 1, FIG. 3 and FIG. 5. FIG. 5 schematically illustrates an intensity-wavelength diagram of visible lights of a phosphor device including a yellow phosphor agent as the second phosphor layer 12, and a yellow phosphor agent mixed with a red phosphor agent as the second phosphor layer 11 of the present invention. It is the comparison with a phosphor device utilizing a yellow phosphor agent and a phosphor device utilizing a red phosphor agent of prior art. FIG. 5 indicates that the intensities of red light (in the R-Color region) of the phosphor device 1 of the present invention shown in FIG. 3 (i.e. the curve Y on Y+R), a phosphor device utilizing a yellow phosphor agent of prior art (i.e. the curve Y) and a phosphor device utilizing a red phosphor agent of prior art (i.e. the curve R). Obviously, the intensity of red light of the phosphor device 1 of the present invention is greater the one of prior art. Furthermore, the following Table I illustrates a comparison data. The weight percentage of the second phosphor agent R is 25% relative to the first phosphor agent Y. The intensity of red light of the phosphor device utilizing a yellow phosphor agent of prior art is assumed as 100% for being the base of the comparison.

**Table I**

| L1 Power (Watts) | Intensity of red light (Y) | Intensity of red light (Y on Y+25wt%R) |
|---|---|---|
| 25 | 100.0% | 121.5% |
| 76 | 100.0% | 116.7% |
| 102 | 100.0% | 116.0% |
| 152 | 100.0% | 111.9% |
| 170 | 100.0% | 110.5% |

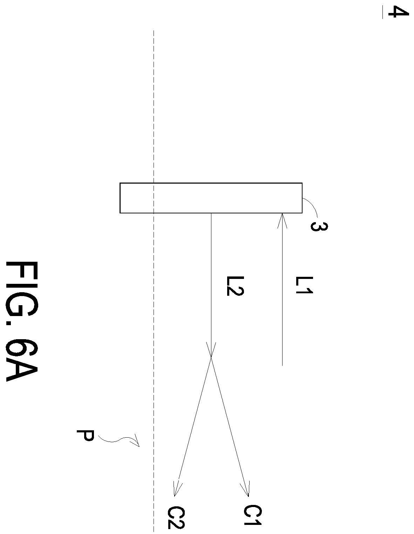

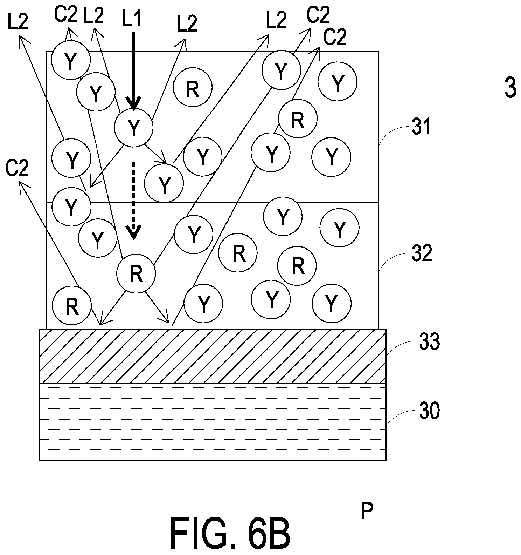

FIG. 6A schematically illustrates a phosphor device including a reflective substrate and an illumination system including the phosphor device according to an embodiment of the present invention. FIG. 6B schematically illustrates the structure of the phosphor device as shown in FIG. 6A. As shown in FIG. 6A and FIG. 6B, a phosphor device 3 including a reflective substrate of an illumination system 4 is disclosed herein. The illumination system 4 emits a first waveband light L1 along an optical path P. The phosphor device 3 includes a substrate 30, a first phosphor layer 31 and a second phosphor layer 32. The substrate 30 is disposed on the optical path P. The first phosphor layer 31 is formed on a side of the substrate 30. The second phosphor layer 32 is formed behind the first phosphor layer 31 along the optical path P. The first phosphor layer 31 includes a first phosphor agent Y and x weight percent (i.e. x wt%) of a second phosphor agent R. The second phosphor layer 32 includes the first phosphor agent Y and y weight percent (i.e. y wt%) of the second phosphor agent R, and y is greater than x (y>x). The first waveband light L1 is converted into a second waveband light L2 by the first phosphor agent Y. The second waveband light L2 includes a first color light C1 and a second color light C2. The first waveband light L1 is converted into the second color light C2 by the second phosphor agent R, thereby increasing the luminous intensity of the second color light C2.

Particularly, x is greater than 0, and y is less than 85. The relationship between x and y is given by 0<x<y<85. That is, the first phosphor layer 31 and the second phosphor layer 32 each includes a specific weight percent of the second phosphor agent R for converting the first waveband light L1 into the second color light C2 in range of 0-85, and the weight concentration of the second phosphor agent R of the second phosphor layer 32 is greater than the weight concentration of the second phosphor agent R of the first phosphor layer 31. In this embodiment, the first phosphor layer 31 is disposed for mainly decreasing the energy of the first waveband light.

The thickness of each of the first phosphor layer 31 and the second phosphor layer 32 is greater than or equal to 10 micrometers, and less than or equal to 500 micrometers. In preferred embodiments, the thickness of each of the first phosphor layer 31 and the second phosphor layer 32 is greater than or equal to 50 micrometers, and less than or equal to 200 micrometers.

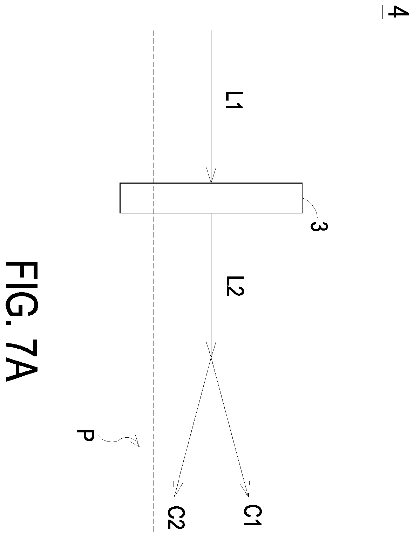

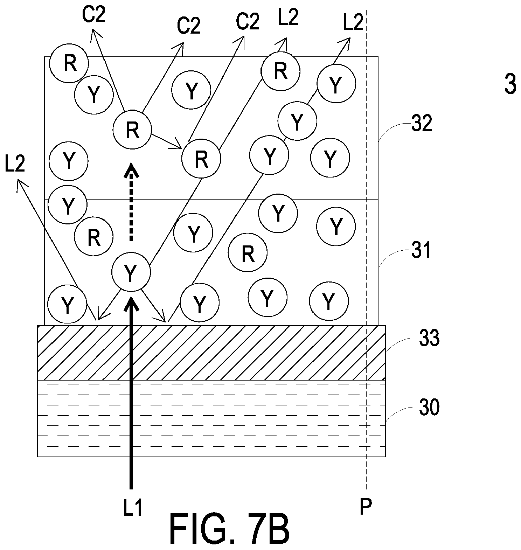

FIG. 7A schematically illustrates a phosphor device including a transmissive substrate and an illumination system including the phosphor device according to an embodiment of the present invention. FIG. 7B schematically illustrates the structure of the phosphor device as shown in FIG. 7A. As shown in FIG. 7A and FIG. 7B, a phosphor device 3 including a transmissive substrate of an illumination system 4 is disclosed herein. The illumination system 4 emits a first waveband light L1 along an optical path P. The phosphor device 3 includes a substrate 30, a first phosphor layer 31 and a second phosphor layer 32. The substrate 30, the first phosphor layer 31 and the second phosphor layer 32 are similar with the above-mentioned embodiment shown in FIGs. 6A and 6B, and are not redundantly described herein. The only difference between this embodiment and the embodiment shown in FIGs. 6A and 6B is that the substrate 30 shown in FIG. 6B is a reflective substrate, and the substrate 30 shown in FIG. 7B is a transmissive substrate.

Table II illustrates a comparison data. The intensity of red light of the phosphor device utilizing a red phosphor agent of prior art is assumed as 100% for being the base of the comparison.

**Table II**

| L1 Power (Watts) | Intensity of red light (Y) | Intensity of red light (R) | Intensity of red light (Y on Y+25wt%R) | Intensity of red light (Y+3.3wt%R on Y+25wt%R) |
|---|---|---|---|---|
| 25 | 84.9% | 100.0% | 102.1% | 109.8% |
| 76 | 119.0% | 100.0% | 138.5% | 138.8% |
| 102 | 134.0% | 100.0% | 154.3% | 151.2% |
| 152 | 162.7% | 100.0% | 182.5% | 173.6% |

From the above descriptions, the present invention provides a phosphor device and a manufacturing method thereof. By utilizing a phosphor layer including a first phosphor agent and a second phosphor agent, the luminous intensity of a color light, which is included in a second waveband light converted by the first phosphor agent, can be increased through the conversion of the second phosphor agent. Meanwhile, since a second phosphor layer including a first phosphor agent and a second phosphor agent is formed behind a first phosphor layer includes only the first phosphor agent along an optical path, most of the energy of a first waveband light is decreased by the first phosphor agent of the first phosphor layer, such that the conversion efficiency of the second phosphor agent is enhanced.

In summary there is disclosed a phosphor device 1, 3 of an illumination system 2, 4 which emits a first waveband light L1, including a substrate 10, 30 and a first phosphor layer 11, 31. The first phosphor layer 11, 31 includes a first phosphor agent Y and a second phosphor agent R. The first phosphor agent Y is formed on the substrate 10, 30 for converting the first waveband light L1 into a second waveband light L2. The second waveband light L2 comprises a first color light C1 and a second color light C2. The second phosphor agent R is distributed over the first phosphor agent Y for converting the first waveband light L1 into the second color light C2 so as to increase the luminous intensity of the second color light C2. Therefore, the luminous intensity of the second color light C2 can be effectively increased.

## Claims

1. A phosphor device (1, 3) of an illumination system (2, 4), the illumination system (2, 4) emitting a first waveband light (L1) to the phosphor device (1, 3) so as to be converted into a second waveband light (L2), the phosphor device (1, 3) comprising:
a substrate (10, 30); wherein a first phosphor layer (11, 31) is formed on the substrate (10, 30), comprising:
a yellow phosphor agent, wherein the first waveband light (L1) is converted into a first color light (C1) and a second color light (C2) by the yellow phosphor agent; and
a red phosphor agent distributed over the yellow phosphor agent for converting the first waveband light (L1) into a third color light, wherein the range of the spectrum of the second color light (C2) and the range of the spectrum of the third color light are at least partially overlapped, and the first color light (C1), the second color light (C2) and the third color light are integrated as the second waveband light (L2); and **characterized in that** the substrate (10,30) is a reflective substrate, and further **characterized by**
a second phosphor layer (12, 32), wherein the second phosphor layer (12,32) is disposed on the first phosphor layer (11, 31), and wherein the second phosphor layer (12, 32) comprises the yellow phosphor agent for simultaneously converting the first waveband light (L1) into the first color light (C1) and the second color light (C2) and decreasing the energy of the first waveband light (L1).

2. A phosphor device (1, 3) of an illumination system (2, 4), the illumination system (2, 4) emitting a first waveband light (L1) to the phosphor device (1, 3) so as to be converted into a second waveband light (L2), the phosphor device (1, 3) comprising: a substrate (10, 30); and a first phosphor layer (11, 31) is formed on the substrate (10, 30), comprising: a yellow phosphor agent, wherein the first waveband light (L1) is converted into a first color light (C1) and a second color light (C2) by the yellow phosphor agent; and a red phosphor agent distributed over the yellow phosphor agent for converting the first wavelength light (L1) into the third color light, wherein the range of the spectrum of the of the second color light (C2) and the range of the third color light are at least partially overlapped, and the first color light (C1), the second color light (C2) and the third color light are integrated as the second waveband light (L2); and **characterized in that** the substrate (10,30) is a transmissive substrate (10,30), and further **characterized in that** the second phosphor layer (12,32) is disposed between the first phosphor layer (11, 31) and the transmissive substrate (10,30), and wherein the second phosphor layer (12,32) comprises the yellow phosphor agent for simultaneously converting the first waveband light (L1) into the first color light (C1) and the second color light (C2) and decreasing the energy of the first waveband light (L1).

3. The phosphor device (1, 3) according to claim 1, wherein the weight percentage of the red phosphor agent is less than 85% relative to the yellow phosphor agent.

4. The phosphor device (1, 3) according to claim 1 wherein the residue power of the first waveband light (L1) inputted from the second phosphor layer (12, 32) into the first phosphor layer (11, 31) is less than 40 watts.

5. The phosphor device (1, 3) according to claim 1 wherein the thickness of each of the first phosphor layer (11, 31) and the second phosphor layer (12, 32) is greater than or equal to 10 micrometers, and less than or equal to 500 micrometers.

6. The phosphor device (1, 3) according to claim 1 wherein the thickness of each of the first phosphor layer (11, 31) and the second phosphor layer (12, 32) is greater than or equal to 50 micrometers, and less than or equal to 200 micrometers.

7. The phosphor device (1, 3) according to one of claims 1-6 further comprising a reflective coating, wherein the reflective coating is disposed between the substrate (10, 30) and the first phosphor layer (11, 31) for reflecting the second waveband light (L2).

8. The phosphor device (1, 3) according to claim 2, wherein the residue power of the first waveband light (L1) inputted from the second phosphor layer (12, 32) into the first phosphor layer (11, 31) is less than 40 watts.

9. The phosphor device (1, 3) according to claim 2 or 8, wherein the thickness of each of the first phosphor layer (11, 31) and the second phosphor layer (12, 32) is greater than or equal to 50 micrometers, and less than or equal to 200 micrometers.

10. The phosphor device (1, 3) according to one of the claims 2, 8, 9 further comprising a reflective coating, wherein the reflective coating is disposed between the substrate (10, 30) and the second phosphor layer (12, 32) for reflecting the second waveband light (L2).

11. The phosphor device (1, 3) according to one of the preceding claims, wherein the first waveband light (L1) is sequentially passed through the second phosphor layer (12, 32) and entered the first phosphor layer (11, 31) along an optical path (P).

12. The phosphor device (1, 3) according to one of the claims 1-11, wherein the second phosphor layer (12, 32) comprises the yellow phosphor agent and the red phosphor agent, and the first waveband light (L1) is sequentially passed through the second phosphor layer (12, 32) and entered the first phosphor layer (11, 31) along an optical path (P), and wherein the ratio of the red phosphor agent to the yellow phosphor agent of the first phosphor layer (11, 31) is y, the ratio of the red phosphor agent to the yellow phosphor agent of the second phosphor layer (12, 32) is x, and y is greater than x, and x is equal to or greater than 0.

13. The phosphor device (1, 3) according to one of the preceding claims, wherein the range of the spectrum of the second color light (C2) and the range of the spectrum of the third color light are completely overlapped.

14. A manufacturing method of a phosphor device (1, 3), comprising steps of: providing a substrate (10, 30); and further comprising the steps of:
forming a first phosphor layer (11, 31) on the substrate (10, 30), wherein the first phosphor layer (11, 31) comprises a first phosphor agent (Y) for converting a first waveband light (L1) into a second waveband light (L2) comprising a first color light (C1) and a second color light (C2), and comprises a second phosphor agent (R) for converting the first waveband light (L1) into the second color light (C2), thereby increasing the luminous intensity of the second color light (C2) outputted by the phosphor device (1, 3); and **characterized in that** the substrate (10, 30) is a reflective substrate, forming a second phosphor layer (12, 32) on the first phosphor layer (11, 31) or wherein the substrate (10,30) is a transparent substrate forming a second phosphor layer (12,32) between the first phosphor layer (11, 31) and the substrate (10, 30), wherein the second phosphor layer (12, 32) comprises the first phosphor agent (Y) for simultaneously converting the first waveband light (L1) into the first color light (C1) and the second color light (C2) and decreasing the energy of the first waveband light (L1).

## Patentansprüche

1. Leuchtstoffvorrichtung (1, 3) eines Beleuchtungssystems (2, 4), wobei das Beleuchtungssystem (2, 4) ein Licht (L1) eines ersten Wellenbereiches zu der Leuchtstoffvorrichtung (1, 3) emittiert, um in ein Licht (L2) eines zweiten Wellenbereiches umgewandelt zu werden, wobei die Leuchtstoffvorrichtung (1, 3) umfasst:
ein Substrat (10, 30);
wobei eine erste Leuchtstoffschicht (11, 31) auf dem Substrat (10, 30) ausgebildet ist, umfassend:
ein gelbes Leuchtstoffmittel, wobei das Licht (L1) des ersten Wellenbereichs durch das gelbe Leuchtstoffmittel in ein Licht einer ersten Farbe (C1) und ein Licht einer zweiten Farbe (C2) umgewandelt wird; und
ein rotes Leuchtstoffmittel, das über das gelbe Leuchtstoffmittel verteilt ist, um das Licht (L1) des ersten Wellenbereichs in Licht einer dritten Farbe umzuwandeln, wobei der Bereich des Spektrums des Lichts der zweiten Farbe (C2) und der Bereich des Spektrums des Lichts der dritten Farbe zumindest teilweise überlappt sind und das Licht der ersten Farbe (C1), das Licht der zweiten Farbe (C2) und das Licht der dritten Farbe als Licht des zweiten Wellenbereichs (L2) integriert sind; und
**dadurch gekennzeichnet ist, dass** das Substrat (10, 30) ein reflektierendes Substrat ist, und ferner **gekennzeichnet ist durch**
eine zweite Leuchtstoffschicht (12, 32), wobei die zweite Leuchtstoffschicht (12, 32) auf der ersten Leuchtstoffschicht (11, 31) angeordnet ist, und wobei die zweite Leuchtstoffschicht (12, 32) das gelbe Leuchtstoffmittel zum gleichzeitigen Umwandeln des Lichts (L1) des ersten Wellenbereichs in das Licht (C1) der ersten Farbe und das Licht (C2) der zweiten Farbe und zum Verringern der Energie des Lichts (L1) des ersten Wellenbereichs umfasst.

2. Leuchtstoffvorrichtung (1, 3) eines Beleuchtungssystems (2, 4), wobei das Beleuchtungssystem (2, 4) ein Licht (L1) eines ersten Wellenbereiches zu der Leuchtstoffvorrichtung (1, 3) emittiert, um in ein Licht (L2) eines zweiten Wellenbereiches umgewandelt zu werden, wobei die Leuchtstoffvorrichtung (1, 3) umfasst: ein Substrat (10, 30); und eine erste Leuchtstoffschicht (11, 31), die auf dem Substrat (10, 30) ausgebildet ist, umfassend: ein gelbes Leuchtstoffmittel, wobei das Licht (L1) eines ersten Wellenbereichs durch das gelbe Leuchtstoffmittel in ein Licht einer ersten Farbe (C1) und ein Licht einer zweiten Farbe (C2) umgewandelt wird; und ein rotes Leuchtstoffmittel, das über das gelbe Leuchtstoffmittel verteilt ist, um das Licht (L1) des ersten Wellenbereichs in das Licht der dritten Farbe umzuwandeln, wobei der Bereich des Spektrums des Lichts der zweiten Farbe (C2) und der Bereich des Lichts der dritten Farbe zumindest teilweise überlappt werden und das Licht der ersten Farbe (C1), das Licht der zweiten Farbe (C2) und das Licht der dritten Farbe als Licht des zweiten Wellenbereichs (L2) integriert werden; und **dadurch gekennzeichnet, dass** das Substrat (10, 30) ein durchlässiges Substrat (10, 30) ist, und ferner **dadurch gekennzeichnet ist, dass** die zweite Leuchtstoffschicht (12, 32) zwischen der ersten Leuchtstoffschicht (11, 31) und dem durchlässigen Substrat (10, 30) angeordnet ist, und wobei die zweite Leuchtstoffschicht (12, 32) das gelbe Leuchtstoffmittel umfasst, um gleichzeitig das Licht (L1) des ersten Wellenbereiches in das Licht (C1) der ersten Farbe und das Licht (C2) der zweiten Farbe umzuwandeln und die Energie des Lichts (L1) des ersten Wellenbereiches zu verringern.

3. Leuchtstoffvorrichtung (1, 3) nach Anspruch 1, wobei der Gewichtsprozentsatz des roten Leuchtstoffmittels weniger als 85% relativ zu dem gelben Leuchtstoffmittel beträgt.

4. Leuchtstoffvorrichtung (1, 3) nach Anspruch 1, wobei die Restleistung des Lichts (L1) des ersten Wellenbereichs, das von der zweiten Leuchtstoffschicht (12, 32) in die erste Leuchtstoffschicht (11, 31) eingespeist wird, weniger als 40 Watt beträgt.

5. Leuchtstoffvorrichtung (1, 3) nach Anspruch 1, wobei die Dicke der ersten Leuchtstoffschicht (11, 31) und der zweiten Leuchtstoffschicht (12, 32) jeweils größer oder gleich 10 Mikrometer und kleiner oder gleich 500 Mikrometer ist.

6. Leuchtstoffvorrichtung (1, 3) nach Anspruch 1, wobei die Dicke der ersten Leuchtstoffschicht (11, 31) und der zweiten Leuchtstoffschicht (12, 32) jeweils größer oder gleich 50 Mikrometer und kleiner oder gleich 200 Mikrometer ist.

7. Die Leuchtstoffvorrichtung (1, 3) nach einem der Ansprüche 1-6 ferner umfassend eine reflektierende Beschichtung, wobei die reflektierende Beschichtung zwischen dem Substrat (10, 30) und der ersten Leuchtstoffschicht (11, 31) angeordnet ist, um das Licht des zweiten Wellenbereichs (L2) zu reflektieren.

8. Leuchtstoffvorrichtung (1, 3) nach Anspruch 2, wobei die Restleistung des Lichts (L1) des ersten Wellenbereichs, das von der zweiten Leuchtstoffschicht (12, 32) in die erste Leuchtstoffschicht (11, 31) eingespeist wird, weniger als 40 Watt beträgt.

9. Leuchtstoffvorrichtung (1, 3) nach Anspruch 2 oder 8, wobei die Dicke der ersten Leuchtstoffschicht (11, 31) und der zweiten Leuchtstoffschicht (12, 32) jeweils größer oder gleich 50 Mikrometer und kleiner oder gleich 200 Mikrometer ist.

10. Die Leuchtstoffvorrichtung (1, 3) nach einem der Ansprüche 2, 8, 9 ferner umfassend eine reflektierende Beschichtung, wobei die reflektierende Beschichtung zwischen dem Substrat (10, 30) und der zweiten Leuchtstoffschicht (12, 32) angeordnet ist, um das Licht (L2) des zweiten Wellenbereichs zu reflektieren.

11. Leuchtstoffvorrichtung (1, 3) nach einem der vorhergehenden Ansprüche, wobei das Licht (L1) des ersten Wellenbereichs nacheinander durch die zweite Leuchtstoffschicht (12, 32) geleitet wird und entlang eines optischen Pfades (P) in die erste Leuchtstoffschicht (11, 31) eintritt.

12. Leuchtstoffvorrichtung (1, 3) nach einem der Ansprüche 1-11, wobei die zweite Leuchtstoffschicht (12, 32) das gelbe Leuchtstoffmittel und das rote Leuchtstoffmittel umfasst und das Licht (L1) des ersten Wellenbereichs nacheinander durch die zweite Leuchtstoffschicht (12, 32) geleitet wird und in die erste Leuchtstoffschicht (11) eintritt, 31) entlang eines optischen Pfades (P), und wobei das Verhältnis des roten Leuchtstoffmittels zu dem gelben Leuchtstoffmittel der ersten Leuchtstoffschicht (11, 31) y ist, das Verhältnis des roten Leuchtstoffmittels zu dem gelben Leuchtstoffmittel der zweiten Leuchtstoffschicht (12, 32) x ist, und y größer als x ist, und x gleich oder größer als 0 ist.

13. Leuchtstoffvorrichtung (1, 3) nach einem der vorstehenden Ansprüche, wobei der Bereich des Spektrums des Lichtes der zweiten Farbe (C2) und der Bereich des Spektrums des Lichtes der dritten Farbe vollständig überlappt sind.

14. Herstellungsverfahren für eine Leuchtstoffvorrichtung (1, 3), das folgende Schritte umfasst:
Bereitstellen eines Substrats (10, 30); und ferner umfassend die Schritte:
Ausbilden einer ersten Leuchtstoffschicht (11, 31) auf dem Substrat (10, 30), wobei die erste Leuchtstoffschicht (11, 31) ein erstes Leuchtstoffmittel (Y) zum Umwandeln eines Lichts (L1) eines ersten Wellenbereichs in ein Licht (L2) eines zweiten Wellenbereichs umfasst, das ein Licht einer ersten Farbe (C1) und ein Licht einer zweiten Farbe (C2) umfasst, und ein zweites Leuchtstoffmittel (R) zum Umwandeln des Lichts (L1) des ersten Wellenbereichs in das Licht (C2) der zweiten Farbe umfasst, wodurch die Lichtintensität des zweiten Farblichts (C2), das von der Leuchtstoffvorrichtung (1, 3) abgegeben wird, erhöht wird; und **dadurch gekennzeichnet ist, dass**
das Substrat (10, 30) ein reflektierendes Substrat ist und durch Ausbilden einer zweiten Leuchtstoffschicht (12, 32) auf der ersten Leuchtstoffschicht (11, 31) oder wobei das Substrat (10, 30) ein transparentes Substrat ist und durch Ausbilden einer zweiten Leuchtstoffschicht (12, 32) zwischen der ersten Leuchtstoffschicht (11, 31) und dem Substrat (10, 30), wobei die zweite Leuchtstoffschicht (12, 32) das erste Leuchtstoffmittel (Y) zum gleichzeitigen Umwandeln des Lichts (L1) des ersten Wellenbereichs in das Licht (C1) der ersten Farbe und das Licht (C2) der zweiten Farbe und zum Verringern der Energie des Lichts (L1) des ersten Wellenbereichs umfasst.

## Revendications

1. Dispositif au phosphore (1, 3) d'un système d'éclairage (2, 4), ledit système d'éclairage (2, 4) émettant une lumière (L1) d'une première gamme de longueurs d'onde vers ledit dispositif au phosphore (1, 3) pour être converti en une lumière (L2) d'une seconde gamme de longueurs d'onde, ledit dispositif au phosphore (1, 3) comprenant :
un substrat (10, 30) ;
dans lequel une première couche de phosphore (11, 31) est formée sur ledit substrat (10, 30), comprenant :
un moyen de luminophore jaune, dans lequel la lumière (L1) de la première gamme de longueurs d'onde est convertie par le moyen de luminophore jaune en une lumière d'une première couleur (C1) et une lumière d'une seconde couleur (C2); et
un moyen de phosphore rouge réparti sur le moyen de phosphore jaune pour convertir la lumière (L1) de la première gamme de longueurs d'onde en lumière d'une troisième couleur, dans lequel la gamme du spectre de la lumière de la deuxième couleur (C2) et la gamme du spectre de la lumière de la troisième couleur se chevauchent au moins partiellement et la lumière de la première couleur (C1), la lumière de la deuxième couleur (C2) et la lumière de la troisième couleur sont intégrées en tant que lumière de la deuxième gamme de longueurs d'onde (L2) ; et
**caractérisé en ce que** le substrat (10, 30) est un substrat réfléchissant, et **caractérisé en outre par**
une deuxième couche de phosphore (12, 32), dans lequel ladite deuxième couche de phosphore (12, 32) est disposée sur ladite première couche de phosphore (11, 31), et dans lequel ladite deuxième couche de phosphore (12, 32) comprend ledit moyen de phosphore jaune pour convertir simultanément la lumière (L1) de la première région de longueur d'onde en la lumière (C1) de la première couleur et la lumière (C2) de la deuxième couleur et pour réduire l'énergie de la lumière (L1) de la première région de longueur d'onde.

2. Dispositif à luminophore (1, 3) d'un système d'éclairage (2, 4), ledit système d'éclairage (2, 4) émettant une lumière (L1) d'une première gamme de longueurs d'onde vers ledit dispositif à luminophore (1, 3) pour être converti en une lumière (L2) d'une deuxième gamme de longueurs d'onde, ledit dispositif à luminophore (1, 3) comprenant : un substrat (10, 30) ; et une première couche de luminophore (11, 31) formée sur ledit substrat (10, 30), comprenant un luminophore jaune, dans lequel la lumière (L1) d'une première région de longueur d'onde est convertie par le luminophore jaune en une lumière d'une première couleur (C1) et une lumière d'une seconde couleur (C2) ; et un moyen de phosphore rouge réparti sur le moyen de phosphore jaune pour convertir la lumière (L1) de la première gamme de longueurs d'onde en lumière de la troisième couleur, dans lequel la gamme du spectre de la lumière de la deuxième couleur (C2) et la gamme de la lumière de la troisième couleur se chevauchent au moins partiellement et la lumière de la première couleur (C1), la lumière de la deuxième couleur (C2) et la lumière de la troisième couleur sont intégrées en tant que lumière de la deuxième gamme de longueurs d'onde (L2) ; et **caractérisé en ce que** le substrat (10, 30) est un substrat transmissif (10, 30), et **caractérisé en outre en ce que** la deuxième couche de phosphore (12, 32) est disposée entre la première couche de phosphore (11, 31) et le substrat transmissif (10, 30), et dans lequel ladite seconde couche de phosphore (12, 32) comprend ledit moyen de phosphore jaune pour convertir simultanément la lumière (L1) de ladite première région de longueur d'onde en la lumière (C1) de ladite première couleur et la lumière (C2) de ladite seconde couleur et réduire l'énergie de la lumière (L1) de ladite première région de longueur d'onde.

3. Dispositif au phosphore (1, 3) selon la revendication 1, dans lequel le pourcentage en poids du phosphore rouge est inférieur à 85% par rapport au phosphore jaune.

4. Dispositif au phosphore (1, 3) selon la revendication 1, dans lequel la puissance résiduelle de la lumière (L1) de la première gamme de longueurs d'onde entrée de la deuxième couche de phosphore (12, 32) à la première couche de phosphore (11, 31) est inférieure à 40 watts.

5. Dispositif au phosphore (1, 3) selon la revendication 1, dans lequel l'épaisseur de la première couche de phosphore (11, 31) et de la deuxième couche de phosphore (12, 32) est respectivement supérieure ou égale à 10 micromètres et inférieure ou égale à 500 micromètres.

6. Dispositif au phosphore (1, 3) selon la revendication 1, dans lequel l'épaisseur de la première couche de phosphore (11, 31) et de la deuxième couche de phosphore (12, 32) est respectivement supérieure ou égale à 50 micromètres et inférieure ou égale à 200 micromètres.

7. Le dispositif au phosphore (1, 3) selon l'une quelconque des revendications 1 à 6 comprenant en outre un revêtement réfléchissant, ledit revêtement réfléchissant étant disposé entre le substrat (10, 30) et la première couche de phosphore (11, 31) pour réfléchir la lumière de la seconde gamme de longueur d'onde (L2).

8. Dispositif au phosphore (1, 3) selon la revendication 2, dans lequel la puissance résiduelle de la lumière (L1) de la première gamme de longueurs d'onde entrée de la deuxième couche de phosphore (12, 32) à la première couche de phosphore (11, 31) est inférieure à 40 watts.

9. Dispositif au phosphore (1, 3) selon la revendication 2 ou 8, dans lequel l'épaisseur de la première couche de phosphore (11, 31) et de la deuxième couche de phosphore (12, 32) est respectivement supérieure ou égale à 50 micromètres et inférieure ou égale à 200 micromètres.

10. Dispositif à luminophore (1, 3) selon l'une des revendications 2, 8, 9 comprenant en outre un revêtement réfléchissant, ledit revêtement réfléchissant étant disposé entre le substrat (10, 30) et la seconde couche de luminophore (12, 32) pour réfléchir la lumière (L2) de la seconde gamme de longueurs d'onde.

11. Dispositif au phosphore (1, 3) selon l'une des revendications précédentes, dans lequel la lumière (L1) de la première région de longueur d'onde est successivement passée à travers la deuxième couche de phosphore (12, 32) et pénètre dans la première couche de phosphore (11, 31) le long d'un chemin optique (P).

12. Dispositif au phosphore (1, 3) selon l'une des revendications 1-11, dans lequel la deuxième couche de phosphore (12, 32) comprend le phosphore jaune et le phosphore rouge, et la lumière (L1) de la première région de longueur d'onde passe successivement à travers la deuxième couche de phosphore (12, 32) et pénètre dans la première couche de phosphore (11), 31) le long d'un chemin optique (P), et dans lequel le rapport du phosphore rouge au phosphore jaune de la première couche de phosphore (11, 31) est y, le rapport du phosphore rouge au phosphore jaune de la deuxième couche de phosphore (12, 32) est x, et y est supérieur à x, et x est égal ou supérieur à 0.

13. Dispositif au phosphore (1, 3) selon l'une des revendications précédentes, dans lequel la plage du spectre de la lumière de la deuxième couleur (C2) et la plage du spectre de la lumière de la troisième couleur se chevauchent complètement.

14. Procédé de fabrication d'un dispositif au phosphore (1, 3) comprenant les étapes suivantes
fournir un substrat (10, 30) ; et comprenant en outre les étapes
former une première couche de phosphore (11, 31) sur ledit substrat (10, 30), dans lequel ladite première couche de phosphore (11, 31) comprend un premier moyen de phosphore (Y) pour convertir une lumière (L1) d'une première région de longueur d'onde en une lumière (L2) d'une deuxième région de longueur d'onde, comprenant une lumière d'une première couleur (C1) et une lumière d'une seconde couleur (C2), et un second moyen de luminophore (R) pour convertir la lumière (L1) de la première région de longueur d'onde en lumière (C2) de la seconde couleur, augmentant ainsi l'intensité lumineuse de la lumière de la seconde couleur (C2) émise par le moyen de luminophore (1, 3) ; et **caractérisé en ce que**
ledit substrat (10, 30) est un substrat réfléchissant et en formant une deuxième couche de phosphore (12, 32) sur ladite première couche de phosphore (11, 31) ou dans lequel ledit substrat (10, 30) est un substrat transparent et en formant une deuxième couche de phosphore (12, 32) entre ladite première couche de phosphore (11, 31) et ledit substrat (10, 30), dans lequel ladite seconde couche de phosphore (12, 32) comprend ledit premier moyen de phosphore (Y) pour convertir simultanément la lumière (L1) de ladite première région de longueur d'onde en la lumière (C1) de ladite première couleur et la lumière (C2) de ladite seconde couleur et pour réduire l'énergie de la lumière (L1) de ladite première région de longueur d'onde.
